# EUROPEAN PATENT APPLICATION

(11) **EP 1 439 398 A1**
(43) Date of publication of application: **21.07.2004**
(21) Application number: 03250275.9
(22) Date of filing: 16.01.2003
(51) Int. Cl.: G01R 31/3185

(54) **Scan chain arrangement**

(71) Applicant: STMicroelectronics, Ltd., Almondsbury, Bristol, BS32 4SQ (GB)
(72) Inventor: Ravenhill, Paul, Eastville, Bristol BS5 6PF (GB); Dellow, Andrew, Minchinhampton, Glos., G16 9JG (GB); Hutson, Matthew, Bristol BS9 3LY (GB)
(74) Representative: Loveless, Ian Mark

(57) **Abstract**

A semiconductor integrated circuit has logic components for testing using scan chains. Scan chains comprise latch components. The scan chains are arranged such that any latch components for storing secret data, such as passwords or keys, are arranged in separate secure scan chains separate from the main scan chains. A security arrangement prevents access to this secure scan chains to unauthorised parties.

## Description

### FIELD OF THE INVENTION

The present invention relates to a method of arranging scan chains, a scan chain arrangement and a semiconductor integrated circuit incorporating scan chains.

### BACKGROUND OF THE INVENTION

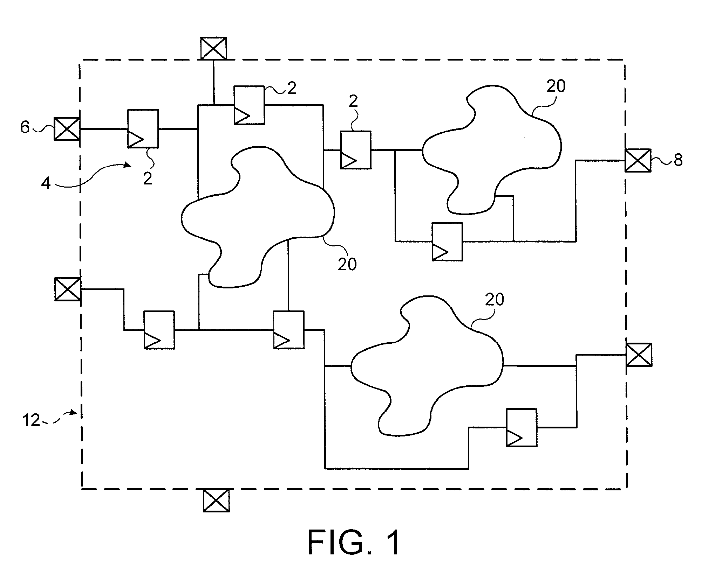

A well-known technique for testing semiconductor integrated circuits is to use scan chains. A scan chain comprises a plurality of latch elements, typically D-type flip-flops connected together in series in a semiconductor circuit. In normal use of the circuit, the D-types are operational as latch elements between logic, but can be changed to scan chain mode for testing. A typical scan chain arrangement is shown in Figure 1.

As can be seen, the scan chains comprise a series of D-type flip-flops 2 connected, in test mode, in series 4 between an input 6 and an output pin 8. The testing of the circuit is performed by presenting a known series of bits known as a test pattern or test vector at the input pin 6 of the chip boundary 12 and reading the output at the output pin 8 which will be modified depending upon the functioning of the intervening circuit shown as logic cloud 20. A correctly functioning circuit produces a given output for a given input. In this way, any faults in the circuit can be detected.

We have appreciated, however, that certain integrated circuits contain portions of memory such as D-types, which contain sensitive data, for example, decryption keys. A possible weakness in the security of systems in which such keys are stored would be to set the circuit to test mode and scan the chains 4, thereby revealing data at an output pin 8 including the decryption keys. Although non-trivial, it may be possible to derive the decryption keys from the scan out data.

A known solution to this problem is to prevent the flip-flops in question from being scannable in the test mode. However, this reduces the effectiveness of testing, as large areas of the circuit are then not scannable. An alternative solution is to reset any such flip-flops containing sensitive data prior to test scanning and reset these flip-flops again after scanning. However, this precludes the possibility of an authorised user capturing functional data from the scan chains in question.

### SUMMARY OF THE INVENTION

We have appreciated the conflicting requirements of testability and security in semiconductor circuits in which any form of sensitive data is stored.

The invention is defined in the claims to which reference is now directed. In an embodiment, the latch elements such as D-type flip-flops containing sensitive data are provided on separate scan chains from other latch elements not containing sensitive data. This allows an authorised user to scan the sensitive scan chains, but a non-authorised user to scan all but the sensitive scan chains giving 99% scan coverage in most practical embodiments without compromising security of sensitive data.

### BRIEF DESCRIPTION OF THE FIGURES

An embodiment of the invention will now be described, by way of example only and with reference to the accompanying figures in which:
- Figure 1:: shows a typical scan chain arrangement;
- Figure 2:: shows a scan chain arrangement embodying the invention; and
- Figure 3:: is a more detailed view of Figure 2.

### DESCRIPTION OF A PREFERRED EMBODIMENT

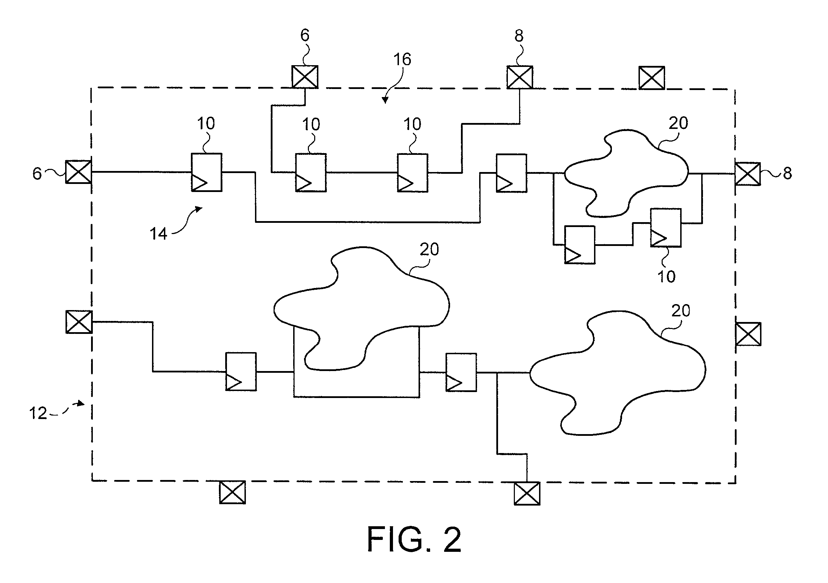

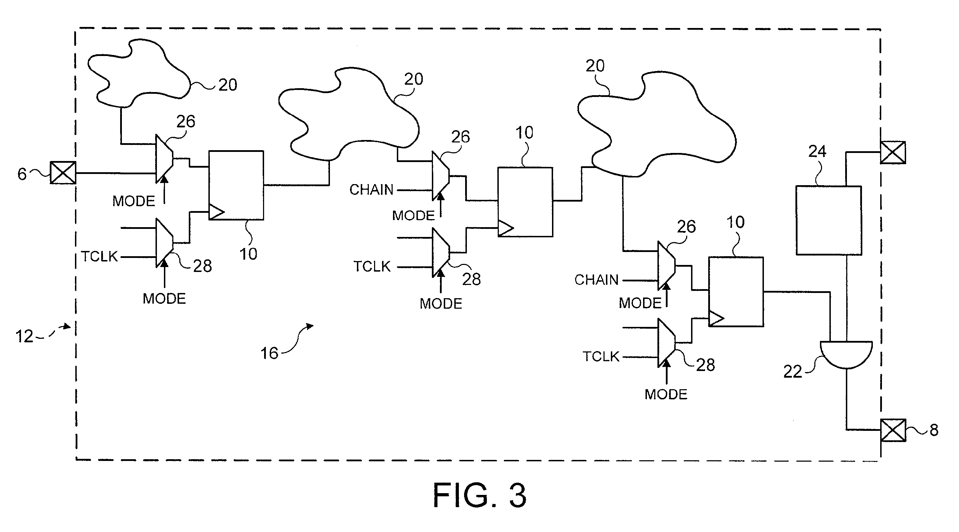

A scan chain arrangement on a semiconductor circuit embodying the invention is shown in Figure 2. the arrangement comprises a series of latch elements 10, here D-type flip-flops (herein D-types) connected within a circuit having further logic components herewith shown as logic clouds 10. The circuit also comprises switches (shown in Figure 3 as multiplexers (MUX)), which are operable to connect the D-types, either to the relevant logic components in the logic clouds in normal use, or in a chain to form a test chain 14.

The pertinent feature of the embodiment is that any D-types which hold data which may be regarded as sensitive, such as a decryption key, are not connected within the normal scan chain arrangement 14, but are connected as a separate secure scan chain 16. This arrangement allows testing of the circuit using the non-secure scan chains 14 without compromising the data within the secure-scan chains 16. Test scan coverage of the majority of the circuit can be achieved without requiring access to the secure scan chains.

If testing of parts of the circuit requires the secure scan chains 16, then this can be done but access to these chains can be restricted by a gating circuit which only allows connection to the secure scan chains if an appropriate input is provided.

The gating circuit comprises a logic AND and further circuitry to ensure only authorised users can obtain access. Such circuitry could, for example, be a key store itself, antifuses, or some form of signature cryptographic circuit using public key/private key technology. If an authorised user applies the appropriate input then the gating circuit allows the chain to connect to the output pin.

The gating circuit and secure scan chains are shown in greater detail in Figure 3. Each D-type 10 has a multiplexer (MUX) 26 at the data input, which is operable to switch the data input from a normal operable source within the circuit to its position in a scan chain. The D-types are shown positioned to have inputs from logic clouds 20 in known fashion. The CHAIN inputs may connect the D-types together such that there is a chain from an input pin 6 at chip boundary 12 to an output pin 8. For simplicity, the interconnections of the chain are not shown, but in any event such chains are well known to the skilled person. To change from operational mode to test mode, a MODE signal is applied to the MUXs 26 and to clock MUXs 28, such that a test clock TCLK is presented at each D-type 10 clock input to clock data through the scan chain.

To prevent sensitive data being presented to an unauthorised user, the output of the secure scan chain 16 is gated by a gating circuit comprising an AND gate 22 and an authentication circuit 24.

The output of the secure scan chain is only presented at output pin 8 if the AND gate receives a logic "1" from the authentication circuit 24. the authentication circuit could take a variety of forms, as previously noted, but is preferably a hardware comparison of a code provided by a user, and a stored code. This ensures that only an authorised user is able to scan data through the secure scan chain 16.

The authentication circuit is preferably accessed by a known Test Access Port (TAP) and the security set within the circuit by non-volatile memory such as anti-fuses.

The design layout process of a semiconductor circuit embodying the invention is as follows.

The circuit itself is designed and a standard testing machines used to determine test scan chains. The D-types which store secure data such as encryption or decryption keys are identified and an instruction provided to the testing machine to separate these D-types as separate, secure scan chains. The layout of the scan chains within the circuit is then defined with the secure scan chains separate from normal scan chains and with a gating circuit at the output of the secure scan chains prior to the output pins.

The circuit so arranged is then operable either in its normal mode (for whatever purpose) or a standard test mode, in which only non-secure scan chains are scanned, or in a secure test mode in which the secure scan chains are also scanned.

It is noted, for the avoidance of doubt, that an embodiment of the invention will have a large number of D-types and scan chains and in this regard the figures are schematic in showing only a few for ease of understanding.

## Claims

1. A semiconductor integrated circuit comprising logic components and latch components of the type in which latch components are arranged as scan chains between input and output pins for testing, wherein latch components for storing secret data are arranged as secure scan chains separate from scan chains comprising latch components for storing non-secret data, and wherein the secure scan chains are only accessible in a secure test mode.

2. A semiconductor integrated circuit according to claim 1, wherein the secure scan chains have a gating circuit arranged to prevent access unless in the secure test mode.

3. A semiconductor integrated circuit according to claim 2, wherein the gating circuit is arranged to prevent scanning out of the secure scan chains unless a correct secure test signal is input to the semiconductor integrated circuit.

4. A semiconductor integrated circuit according to claim 3, wherein the gating circuit is governed by an authentication circuit comprising a hardware comparison arrangement to compare the input secure test signal with a stored test signal.

5. A semiconductor integrated circuit according to any preceding claim, wherein the gating circuit is an AND gate.

6. A method of producing semiconductor integrated circuits of the type having latch components arranged as scan chains for testing, comprising identifying latch components that will store secret data in use, arranging the latch components identified as storing secret data as secure scan chains, arranging latch components not identified as storing secret data as normal scan chains, configuring the secure scan chains such that they are accessible only to authorised users, and producing a semiconductor integrated circuits so arranged.
